(19) Europäisches Patentamt / European Patent Office / Office européen des brevets

(11) EP 2 130 059 B1

# (12) EUROPEAN PATENT SPECIFICATION

(45) Date of publication and mention of the grant of the patent:
**11.04.2012 Bulletin 2012/15**

(21) Application number: **08718138.4**

(22) Date of filing: **20.03.2008**

(51) Int Cl.:
***G01R 33/50*** *(2006.01)*

(86) International application number:
**PCT/EP2008/053434**

(87) International publication number:
**WO 2008/116846 (02.10.2008 Gazette 2008/40)**

## (54) METHOD FOR DETERMINING PHASE-CORRECTED AMPLITUDES IN NMR RELAXOMETRIC IMAGING

VERFAHREN ZUR BESTIMMUNG VON PHASENKORRIGIERTEN AMPLITUDEN BEI DER RELAXOMETRISCHEN NMR-BILDGEBUNG

PROCÉDÉ POUR DÉTERMINER LES AMPLITUDES CORRIGÉES EN PHASE DANS UNE IMAGERIE RELAXOMÉTRIQUE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **23.03.2007 EP 07290353**

(43) Date of publication of application:
**09.12.2009 Bulletin 2009/50**

(73) Proprietors:
- **Institut Curie**
**75005 Paris (FR)**
- **INSERM - Institut National de la Santé et de la Recherche Médicale**
**75013 Paris (FR)**

(72) Inventors:
- **MISPELTER, Joël**
**F-78690 Saint Rémy l'Honoré (FR)**
- **LUPU, Michaela**
**F-91400 Orsay (FR)**

(74) Representative: **Pontet, Bernard**
**Pontet Allano & Associés**
**25, Rue Jean Rostand**
**Parc Club Orsay Université**
**91893 Orsay Cedex (FR)**

(56) References cited:
- **EDZES H T ET AL: "Quantitative T2 imaging of plant tissues by means of multi-echo MRI microscopy" MAGNETIC RESONANCE IMAGING, TARRYTOWN, NY, US, vol. 16, no. 2, 1998, pages 185-196, XP002346674 ISSN: 0730-725X**
- **VAN DER WEERD L ET AL: "Evaluation of algorithms for analysis of NMR relaxation decay curves" MAGNETIC RESONANCE IMAGING ELSEVIER USA, vol. 18, no. 9, November 2000 (2000-11), pages 1151-1157, XP002448420 ISSN: 0730-725X cited in the application**
- **PERMAN W H ET AL: "Methodology of in vivo human sodium MR imaging at 1.5 T." RADIOLOGY SEP 1986, vol. 160, no. 3, September 1986 (1986-09), pages 811-820, XP002448421 ISSN: 0033-8419**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 130 059 B1

Printed by Jouve, 75001 PARIS (FR)

## Description

TECHNICAL FIELD

This invention relates to a method for determining phase-corrected amplitudes in a multiple echoes imaging experiment, wherein a Fast Fourier Transform FFT reconstruction is applied to the signals generated by a CPMG (Carr-Purcell-Meiboom-Gill) sequence.

BACKGROUND OF THE INVENTION

In research studies or in clinical investigations, images are used not only for evidencing the inner structures of the body but also for quantifying the available NMR (nuclear magnetic resonance) parameters, like T1, T2 or the apparent diffusion coefficient, D (known as proton density). T1, "spin-lattice" relaxation parameter, is by definition, the component of relaxation which occurs in the direction of the ambient magnetic field. T2, "spin-spin" relaxation parameter, is by definition, the component of true relaxation to equilibrium that occurs perpendicular to the ambient magnetic field. Recently, sodium T2 evolution on the treatment time-course of ADC (apparent diffusion coefficient) changes in targeted tissues are more and more considered as possible early apoptosis markers, hence important NMR parameters to be taken into consideration in research or in clinical treatment. Alkali ions, like sodium and potassium are considered to deliver important biological information whenever cellular metabolic processes are occurring, like apoptosis or necrosis. Unfortunately, $^{23}$Na imaging, as well as other biological interesting nuclei, suffers from inherently low sensitivity that makes often the accurate quantifying difficult.

In these conditions it becomes of a major importance the correct determination of the relaxation time constants characteristic for targeted tissues, determined from a Region Of Interest (ROI) specified on the reconstructed image.

The great majority of reconstruction methods implemented on the imaging machines are using the absolute amplitude (modulus) in order to obtain the final image. This method uses the pair of images representing the real and imaginary components of the FFT transform to calculate the magnitude of each corresponding complex pair. If the real and imaginary pairs are given by Re = $A_r + \varepsilon_r$, and Im = $A_i + \varepsilon_i$, (where $A_r$ and $A_i$ are the real and imaginary components of the signal, while $\varepsilon_r$ and $\varepsilon_i$ are the real and imaginary components of the noise), it is obvious that calculating the absolute value, given by $M = \sqrt{\mathrm{Re}^2 + \mathrm{Im}^2}$, will place every point in the reconstruction grid upon a certain positive value, given by the rectified noise level.

The presence of the positive level given by the noise absolute value is affecting the accurate determinations for the NMR relaxation parameters such as $T_1$, $T_2$ or for D as well as any result of pixels algebra. This effect is even more important for poor signal to noise ratio (SNR) images, like sodium images, affecting the quantitative information they can produce. Nevertheless, even in the case of high SNR ratio proton images, multi - exponential relaxation may be totally covered up or extremely biased by the positive noise level.

The need to quantitatively determine the relaxation time constants, especially from non-exponential decays, leads to some mathematical manipulations in order to extract more accurately the transformed signal amplitudes.

The use of power magnitude values is re-creating a Gaussian quality for the noise by subtracting the average noise level. However, this power routine is only valid for mono-exponential relaxation decays, while most of the biological samples are heterogeneous and thus non-exponential.

Another way to avoid the undesired biased noise produced by magnitude calculation is to phase-correct the images. In the prior art, an attempt to obtain phase-corrected images was done by Louise van der Weerd, Frank J. Vergeldt, P. Adrie de Jager, Henk Van As, "Evaluation of Algorithms for Analysis of NMR Relaxation Decay Curves."; Magnetic Resonance Imaging 18 (2000) 1151-1157. Their algorithm is based on the phase calculation of every pixel but using only the first and second echo images. The resulting correction is further applied to all subsequent echoes in the sequence. The first two echoes are thus becoming magnitude images while the rest of echo images are real, phase corrected ones. This method is based on the assumption that the first two points in the relaxation decay are less affected by the noise bias and thus, the phase corrected amplitude may be approximated by the absolute value. Nevertheless, when extracting the decay curve from the whole echoes train, a small bias is still introduced by using only the first two points, characterised by the highest SNR values. This imperfection is increasing more for poor signal to noise images.

SUMMARY OF THE INVENTION

The object of the present invention is a simple and fast algorithm for obtaining real-phased images in a multiple echoes Magnetic resonance imaging (MRI) experiment.

Another object of the present invention is to keep the relaxation decay unperturbed by the phasing process, whatever the level of noise.

Another object of the present invention is a new method which is valid for multi-exponential decay curves.

At least one of the above-mentioned objects is achieved with a method according to the present invention for determining phase-corrected amplitudes in a multiple echoes imaging experiment, wherein a Fast Fourier Transform FFT reconstruction is applied to the signals

generated by a CPMG sequence. Said signals correspond to echo images. The present invention uses a pixel-by-pixel phase correction. One ordinary skilled in the art knows that echo images consist of an evolution of an image according to the time. Thus, the amplitude of a same pixel, through the echo images, describes a decay curve. According to the present invention, for each pixel, said pixel being the same through the echo images, the method comprising the steps of:

- plotting the complex amplitudes of at least two echo images in a complex plane,
- defining a linear fit from the plot,
- determining a rotation angle alpha ($\alpha$) which is the angle between said linear fit and the real axis of the complex plane,
- determining the rotation angle $\alpha_{min}$ which is an optimization of the rotation angle $\alpha$ by minimizing the sum of the squared imaginary components of the amplitudes,
- performing a rotation for amplitudes of all echo images with the rotation angle $\alpha_{min}$ in order to determine the phase-corrected amplitudes.

As a matter of fact, one ordinary skilled in the art knows that the amplitude is not only affected to a pixel but rather to a voxel. The pixel representation is commonly used in the technical domain of the invention. The rotation angle $\alpha$ is the phase of the magnetization created in the considered voxel.

In accordance with the present invention, the linear fit can be a straight line obtained by linear regression.

With the present invention, the phase correction is achieved by rotating all the FFT coefficients in the complex plane, such as all information is transferred to the real component while the imaginary one tends to the noise level.

Contrary to the Weerd et al document, the present invention maximises all real components of amplitudes. This is a simple and fast method obtaining real-phased images, enabling an accurate determination of T2 constants on an arbitrary ROI of an image. Phased-corrected amplitudes on single pixel may add correctly, without biasing the result, in order to improve the S/N of the decay to be analysed. Moreover, an improved contrast for the phase corrected images as compared to the module images has been observed.

The method according to the invention is sufficiently robust to function for a small number of echoes. However, for some experiences, the step of plotting the amplitudes may consist of plotting the amplitudes of at least six echo images in the complex plane. For some experiences in which the decay curve has to be fit with high precision, at least eight echo images may be used to plot the amplitudes in the complex plane.

However, the step of plotting the amplitudes preferably consists of plotting the amplitudes of all the echo images in the complex plane. In fact, bigger is the number of echo images used, bigger is the precision. With the method of the present invention, the noise concerning the CPMG sequence is not modified and the shape of the decay curve is not modified. Thus, it is possible to precisely fit the decay curve concerning a pixel in order to accurately determine relaxometry parameters. On the contrary, Weerd describes a method in which the shape of the decay curve is modified: indeed the first and second echo images in Weerd are magnitude images and an angle obtained from said first and second echo image is applied to the rest of the echo images.

The present invention is notably remarkable by the fact that it corrects the phase of the entire image, by phasing each pixel separately, using all the echo images available in the sequence. More, the amplitude values used for creating the relaxation decays are not biased for any point while the Gaussian characteristic of the noise is kept. The procedure allows both the accurate T2 determination for any ROI defined on an image obtained by a multiple echoes experiment, like MSME, for example, and correct image algebra, if required.

Moreover, the use of all echo images together with the minimizing step provides the method of the invention with robustness and stability independently of the SNR.

The method of the present invention is well adapted for spin echo sequence where all echoes corresponding to a given pixel have the same phase.

Advantageously, the Golden Search routine can be used to minimize the sum of the squared imaginary components of the amplitudes.

In accordance with the present invention the phase-corrected amplitudes are fitted by using a fitting algorithm. For example, said fitting algorithm is the Singular Value Decomposition (SVD) method.

In accordance with the present invention, the real components of the phase-corrected amplitudes are used to reconstruct a real image and the imaginary components of the phase-corrected amplitudes are used to reconstruct an imaginary image. The real phase-corrected images have the advantage of preserving the same noise characteristics as the original acquired signals corresponding to the CPMG sequence.

Advantageously, at least one of NMR parameters T1, T2 and D, is determined from said phase-corrected amplitudes.

According to another aspect of the invention, it is proposed an imaging machine wherein images are determined from said phase-corrected amplitudes.

These and many other features and advantages of the invention will become more apparent from the following detailed description of the preferred embodiments of the invention.

## BRIEF DESCRIPTION OF THE DRAWING FIGURES

- Figures 1a-1c show raw data for a sodium image reconstructed in complex mode (1a, 1b) and an absolute value mode (1c) according to the prior art;
- Figures 2a-2d show Singular Value Decomposition of a decay signal in module, without (2a, 2b) and with (2c, 2d) base line correction according to the prior art;
- Figures 2e and 2f show Singular Value Decomposition of a decay signal obtained after a phase correction procedure according to the present invention;
- Figure 3 is a flow chart of an algorithm according to the present invention;
- Figures 4a and 4b illustrate experimental data points of one pixel represented in the complex plane and as a function of time, before (4a) and after (4b) phase correction according to the present invention; and
- Figures 5a-5d illustrate raw data for a sodium image after phasing procedure (5a and 5b), and example of reconstructed corresponding images (5c and 5d).

DETAILED DESCRIPTION

Although the invention is not limited thereto, one now will describe a phase correction routine applied to sodium images, characterised by rather poor SNR values, in ghost samples as well as in vivo mouse liver. The exponential decays thus obtained were fitted using the Singular Value Decomposition method in order to obtain objective fitting parameters. However, the phasing method proposed is obviously completely independent of the fitting algorithm, any other fitting method being suited as well.

Now will be described material used to experiment the method according to the present invention. The general purpose is to determine imaging data from a CPMG multi-slice multi-echo (MSME) sequence. The CPMG sequence used consists of a spin echo pulse sequence comprising a 90° radio frequency pulse followed by an echo train induced by successive 180° pulses and is useful for measuring $T_2$ weighted images.

In vivo sodium liver MR (magnetic resonance) images, as well as $^{23}$Na ghost images were recorded using a double tuned quadrature birdcage resonating at 53 MHz for sodium and 200 MHz for proton. The probe is linear at proton frequency, being needed for localisation purposes only. The sodium images were acquired using a 8 to 32 echoes MSME pulse sequence at 4.7 T. The ghost sample contained two regions characterised by different Na ions mobility due to two different agarose concentrations (bound Na ions at 1% agarose and more freely moving ions at 0.15 % agarose concentration). The different motional sodium compartments are characterised by different spin-spin relaxation times, being an ideal test for the correctness of the phase correction method. The sodium concentration in both compartments is 75 mM, corresponding to an average sodium concentration internal in living systems. In vivo sodium images were done on tumoral mice liver. The experimental conditions were: FOV=68 mm, TE= 6.035 ms, Slice thickness=6 mm, Spectral width = 25 kHz, reconstruction matrix= 64x64.

All the images were reconstructed using Paravision® 3.02, in absolute value, real and imaginary modes.

The best suited method to get an objective evaluation of the relaxation data, represented
by a multi exponential decay,

$$f(t)=\sum_{i=1}^{n} c_i \exp(b_i.t) \qquad (1)$$

is the singular value decomposition (SVD) fitting method. The unknown exponents $b_i$ and coefficients $c_i$ of Eq. (1) should be obtained from a given set $\{\gamma_j \mid j = 0..[2m-1)\}$ of 2m noisy data points.

The data values yi as obtained from the $T_2$ decay, are rearranged in a matrix form having a Hankel structure:

$$H=\begin{bmatrix} Y_0 & Y_1 & . & . & Y_{q-1} \\ . & . & . & . & . \\ . & . & . & . & . \\ . & . & . & . & . \\ Y_{p-1} & Y_p & . & . & Y_{p+q+1} \end{bmatrix}, \ H_{i,j} = Y_{i+j-1}$$

where the indices i and j represent consecutive amplitudes of the echo train. For 2m data points, p=q=m. Such matrices are easily factorised using the SVD theorem: $H = U.\Sigma.V^T$, where U and V are orthogonal and $\Sigma$ is the diagonal singular values matrix. The singular values are directly related to the exponents involved in the decays. This fitting method provides on one hand an objective criterion regarding the number of exponentials existing in a decay curve and on the other being sensitive to the noise level, gives a criterion about the data accuracy.

Reference is now made to the drawing figures 1 and 2 concerning the results according to a standard processing method of prior art.

Figures 1a and 1b illustrates raw data for a sodium image reconstructed in complex mode. Figure 1a concerns the real part, whereas figure 1b the imaginary part. Said figures 1a and 1b present the Gaussian noise, added to both the real and imaginary parts of the sodium image, as acquired on both channels from an usual imaging experiment. The noise is fluctuating around zero level, having positive as well as negative values. On the other hand, the common magnitude representation of the transformed signals, on figure 1c, produces only positive values, fluctuating around a positive bias level, giving thus the Rician characteristic to the noise. According to

the standard method, the noise is highly rectified.

All data amplitudes, that are further used for quantitative determinations, are situated upon this positive level. The consequences resulting from this noise "rectification" on the decay analysis are easy to be seen when displaying the spin-spin relaxation decays given by the "two relaxation compartments" agarose sample used for this study. The exponentially relaxing compartment is given by sodium ions that are moving almost freely, averaging the quadrupolar interactions with the surrounding electric field gradients (smaller compartment) while the bigger one is relaxing bi-exponentially due to the non-averaged quadrupolar interactions of sodium ions with the macromolecules of agarose. The 32 magnitude echoes give the decays shown in figures 2a-2d for the two compartments, both decays being situated upon the positive bias given by the noise magnitude level. Figures 2a-2d shows a Singular Value Decomposition of amplitudes in absolute value concerning two ROIs (Regions Of Interest). Figures 2a and 2c concern a first ROI, whereas figures 2b and 2d concern a second ROI. Figures 2a and 2b relate to a decomposition without base line extraction. Figures 2c and 2d relate to a decomposition obtained after base line correction. Figures 2e and 2f relate to a decomposition obtained after the phase correction procedure which is described from figures 3-5.

The corresponding Singular Value Decomposition shows two singular values detaching from noise for both mono-exponentially and bi-exponentially relaxing compartments (Fig 2a and 2b). When tempting to extract the positive bias, the SVD analysis is showing only one singular value for the biexponential compartment (Fig. 2c) suggesting that before extraction, the second singular value was characterising the noise positive bias only. It becomes obvious that phase corrected images are required in order to produce accurate quantitative analysis of the relaxation decays on heterogeneous samples as shown in Figures 2e and 2f.

Reference is now made to the drawing figures 3-5 concerning a method to correct the phase of images according to the invention.

The first step for achieving the phase corrected decays according to the present invention, is to plot the amplitudes, for a given pixel, as given by the multiple echoes experiment in the complex plane, i.e. real data array versus imaginary data array. Due to the fact that in a multi-echoes experiment all the echoes have the same phase, this plot is a straight line. Its linear fit will provide the phase of the magnetization created in the considered voxel. Figure 3 shows a flow chart of an algorithm according to the present invention. The first step 1 concerns the definition of the linear fit. The corresponding rotation angle alpha ($\alpha$), defined at the step 2, maximizes the real amplitudes while minimizing the imaginary ones. Screen 7 and 8 show the determination of the linear fit 10 which is the best straight line passing through maximum of points representing amplitudes values of one pixel. After rotation by $\alpha$, the linear fit is on the real axis. According to a preferred embodiment of the invention, all echoes amplitudes are participating to the angle $\alpha$ definition which improves the accuracy of the phase correction. After performing the rotation for all data with the determined angle alpha, all amplitudes in the complex plane are characterized by imaginary values close to zero, limited only by the S/N value, screen 8 on figure 3.

The rotation angle so-far obtained can only be considered as an initial value. The accuracy and stability of the algorithm is indeed improved if the rotation angle for the phase correction is optimized by minimizing the imaginary amplitudes at the step 3. Step 4 concerns a definition of $\chi^2$ which is the sum of the squared imaginary components. This minimization uses a routine of Golden Search, at the step 5, around the determined value. The final rotation angle with $\alpha_{min}$ is thus determined at step 6, for each pixel providing the real phase-corrected images. Screen 9 is a representation of the optimization of angle $\alpha$.

The phasing procedure is exemplified on figure 4 for a given pixel of noisy sodium echoes images obtained for the agarose sample. Figure 4a illustrates the experimental data points represented in the complex plane and as a function of time before the phase correction, whereas figure 4b illustrates a similar representation but after the phase correction according to the present invention. The algorithm proves to be very robust even for poorer signal to noise ratio and smaller number of echoes.

When applying the algorithm according to the invention over the entire images, maximum amplitude real images are obtained while the imaginary one tends to noise level. The results of the phasing routine are shown in figures 5a-5d. Figures 5a and 5b respectively illustrate real part and imaginary part of raw data for a sodium image after phasing procedure.

Figures 5c and 5d illustrate an example of reconstructed corresponding images. Advantageously, the method according to the present invention can thus be applied to reconstruct sodium image.

Although the various aspects of the invention have been described with respect to preferred embodiments, it will be understood that the invention is entitled to full protection within the full scope of the appended claims.

## Claims

1. Method for determining phase-corrected amplitudes in a multiple echoes imaging experiment, wherein a Fast Fourier Transform FFT reconstruction is applied to the echo signals generated by a CPMG sequence; for each pixel, said pixel being the same through the echo images, the method comprising the steps of:

   - plotting the amplitudes of at least two echo images in a complex plane,
- defining a linear fit from the plot,
- determining a rotation angle $\alpha$ which is the angle between said linear fit and the real axis of the complex plane,
- determining the rotation angle $\alpha_{min}$ which is an optimization of the rotation angle $\alpha$ by minimizing the sum of the squared imaginary components of the amplitudes,
- performing a rotation for amplitudes of all echo images with the rotation angle $\alpha_{min}$ in order to determine the phase-corrected amplitudes.

**2.** Method according to claim 1, **characterized in that** the step of plotting the amplitudes consists of plotting the amplitudes of at least six echo images in the complex plane.

**3.** Method according to claim 1, **characterized in that** the step of plotting the amplitudes consists of plotting the amplitudes of all the echo images in the complex plane.

**4.** Method according to any of preceding claims, **characterized in that** the Golden Search routine is used to minimize the sum of the squared imaginary components of the amplitudes.

**5.** Method according to any of preceding claims, **characterized in that** the phase-corrected amplitudes are fitted by using a fitting algorithm.

**6.** Method according to claim 5, **characterized in that** the fitting algorithm is the Singular Value Decomposition (SVD) method.

**7.** Method according to any of preceding claims, **characterized in that** the real components of the phase-corrected amplitudes are used to reconstruct a real image and the imaginary components of the phase-corrected amplitudes are used to reconstruct an imaginary image.

**8.** Method according to any of preceding claims, wherein at least one of NMR parameters T1, T2 and D, is determined from phase-corrected amplitudes.

**9.** Imaging machine wherein images are determined from phase-corrected amplitudes obtained according to any of preceding claims.

**10.** Application of a method according to claims 1-8, wherein said method is applied to reconstruct sodium image.

**Patentansprüche**

**1.** Verfahren zur Bestimung von phasenkorrigierten Amplituden in einem Mehrfach-Echo-Bildgebungsexperiment, wobei eine schnelle Fourier-Transformations(FFT)-Rekonstruktion auf die Echo-Signale, welche durch eine CPMG-Sequenz erzeugt wurden, angewendet wird, wobei die Methode für jeden Punkt, wobei dieser Punkt der selbe durch die Echobilder ist, folgende Schritte aufweist:

- Auftragen der Amplituden von wenigstens zwei Echobildern in einer komplexen Ebene,
- Definieren einer Ausgleichsgeraden aus dem Auftrag,
- Bestimmung eines Drehwinkels $\alpha$, welcher der Winkel zwischen der Ausgleichsgeraden und der Real-Axe der komplexen Ebene ist,
- Bestimmung des Drehwinkels $\alpha_{min}$, welcher eine Optimierung des Drehwinkels $\alpha$ durch Minimieren der Summe der quadrierten Imaginärteile der Amplituden ist,
- Durchführen einer Drehung für Amplituden aller Echobilder mit dem Drehwinkel $\alpha_{min}$, um die phasenkorrigierten Amplituden zu bestimmen.

**2.** Verfahren nach Anspruch 1, **dadurch gekennzeichnet, dass** der Schritt des Auftragens der Amplituden das Auftragen von wenigstens sechs Echobildern in der komplexen Ebene umfasst.

**3.** Verfahren nach Anspruch 1, **dadurch gekennzeichnet, dass** der Schritt des Auftragens der Amplituden das Auftragen aller Echobilder in der komplexen Ebene umfasst.

**4.** Verfahren nach einem der vorangehenden Ansprüche, **dadurch gekennzeichnet, dass** die goldene Suchroutine benutzt wird, um die Summe der quadrierten Imaginärteile der Amplituden zu minimieren.

**5.** Verfahren nach einem der vorangehenden Ansprüche, **dadurch gekennzeichnet, dass** die phasenkorrigierten Amplituden durch die Anwendung eines Approximationsalgorithmus approximiert werden.

**6.** Verfahren nach Anspruch 5, **dadurch gekennzeichnet, dass** der Approximationsalgorithus die Singulärwertzerlegung (SVD) ist.

**7.** Verfahren nach einem der vorangehenden Ansprüche, **dadurch gekennzeichnet, dass** die Realteile der phasenkorrigierten Amplituden dazu verwendet werden, ein Realbild zu rekonstruieren und dass die Imaginärteile der phasenkorrigierten Amplituden dazu verwendet werden, ein Imaginärbild zu rekonstruieren.

8. Verfahren nach einem der vorangehenden Ansprüche, **dadurch gekennzeichnet, dass** wenigstens einer der NMR-Parameter T1, T2 und D aus den phasenkorrigierten Amplituden bestimmt wird.

9. Bildgebungsvorrichtung, bei der Bilder aus phasenkorrigierte Amplituden, welche nach einem der vorangehenden Ansprüche erhalten werden, bestimmt werden.

10. Anwendung eines Verfahrens nach einem der Ansprüche 1 bis 8, wobei das Verfahren angewendet wird, um ein Natriumbild zu rekonstruieren.

## Revendications

1. Procédé de détermination d'amplitudes corrigées en phase dans une expérience d'imagerie par échos multiples, dans lequel une reconstruction par transformée de Fourier rapide FFT est appliquée aux signaux d'écho générés par une séquence CPMG ; pour chaque pixel, ledit pixel étant le même dans les images d'écho, le procédé comprenant les étapes consistant à :

   - tracer les amplitudes d'au moins deux images d'écho dans un plan complexe,
   - définir un ajustement linéaire à partir du tracé,
   - déterminer un angle de rotation $\alpha$ qui est l'angle entre ledit ajustement linéaire et l'axe réel du plan complexe,
   - déterminer l'angle de rotation $\alpha_{min}$ qui est une optimisation de l'angle de rotation $\alpha$ en minimisant la somme des composantes imaginaires élevées au carré des amplitudes,
   - réaliser une rotation des amplitudes de toutes les images d'écho avec l'angle de rotation $\alpha_{min}$ afin de déterminer les amplitudes corrigées en phase.

2. Procédé selon la revendication 1, **caractérisé en ce que** l'étape de traçage des amplitudes consiste à tracer les amplitudes d'au moins six images d'écho dans le plan complexe.

3. Procédé selon la revendication 1, **caractérisé en ce que** l'étape de traçage des amplitudes consiste à tracer les amplitudes de toutes les images d'écho dans le plan complexe.

4. Procédé selon l'une quelconque des revendications précédentes, **caractérisé en ce que** le programme Golden Search est utilisé pour minimiser la somme des composantes imaginaires élevées au carré des amplitudes.

5. Procédé selon l'une quelconque des revendications précédentes, **caractérisé en ce que** les amplitudes corrigées en phase sont ajustées en utilisant un algorithme d'ajustement.

6. Procédé selon la revendication 5, **caractérisé en ce que** l'algorithme d'ajustement est la méthode de la décomposition en valeurs singulières (DVS).

7. Procédé selon l'une quelconque des revendications précédentes, **caractérisé en ce que** les composantes réelles des amplitudes corrigées en phase sont utilisées pour reconstruire une image réelle et les composantes imaginaires des amplitudes corrigées en phase sont utilisées pour reconstruire une image imaginaire.

8. Procédé selon l'une quelconque des revendications précédentes, dans lequel au moins l'un des paramètres RMN T1, T2 et D est déterminé à partir d'amplitudes corrigées en phase.

9. Machine d'imagerie dans laquelle des images sont déterminées à partir d'amplitudes corrigées en phase obtenues selon l'une quelconque des revendications précédentes.

10. Application d'un procédé selon les revendications 1 à 8, dans laquelle ledit procédé est appliqué pour reconstruire une image au sodium.

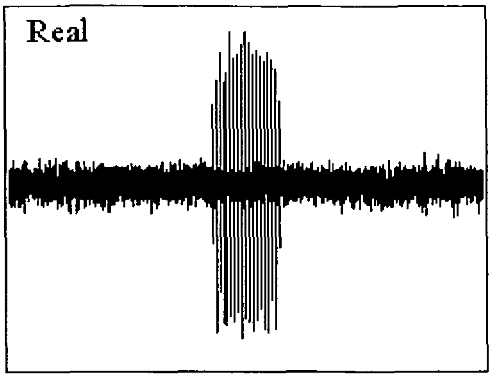


FIGURE 1a
(prior art)

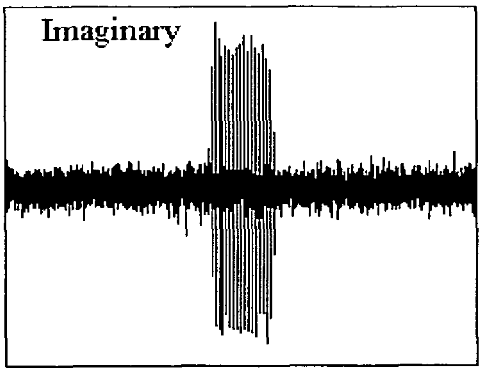


FIGURE 1b
(prior art)

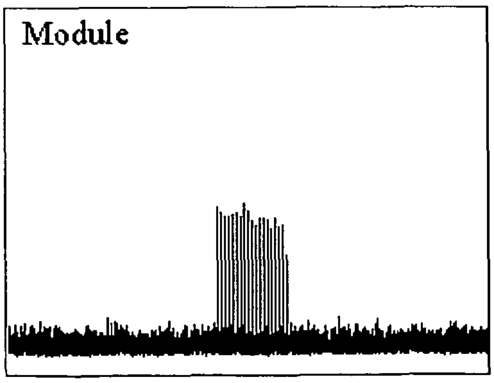


FIGURE 1c
(prior art)

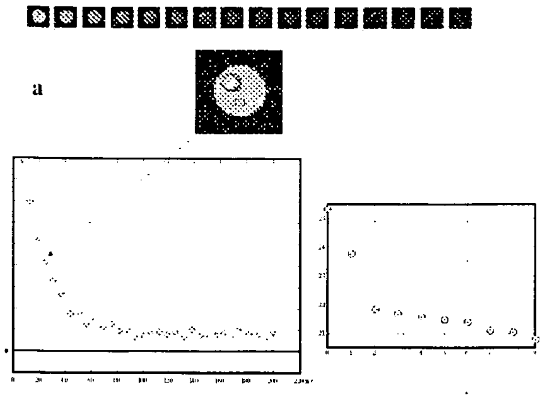


FIGURE 2a
(Prior art)

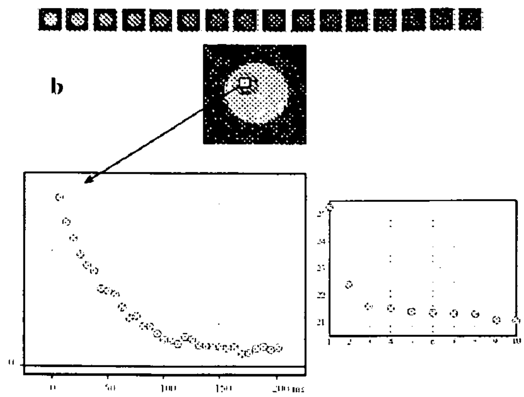


FIGURE 2b
(Prior art)

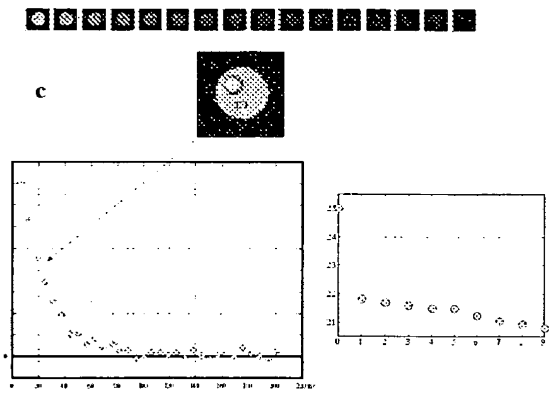


FIGURE 2c
(Prior art)

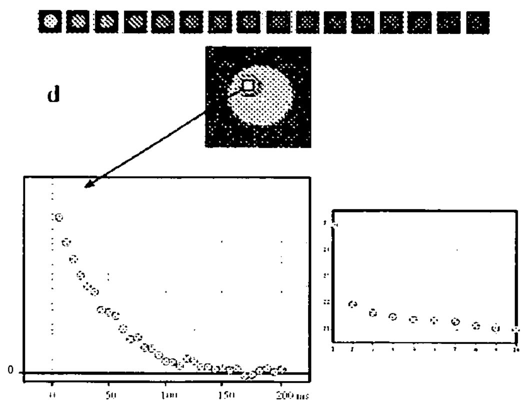


FIGURE 2d
(Prior art)

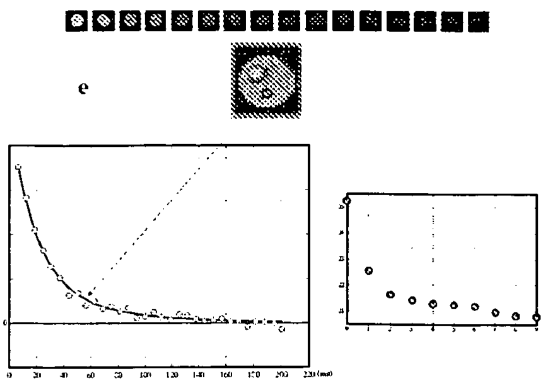


FIGURE 2e

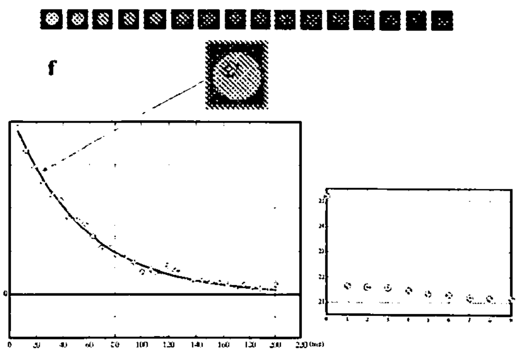


FIGURE 2f

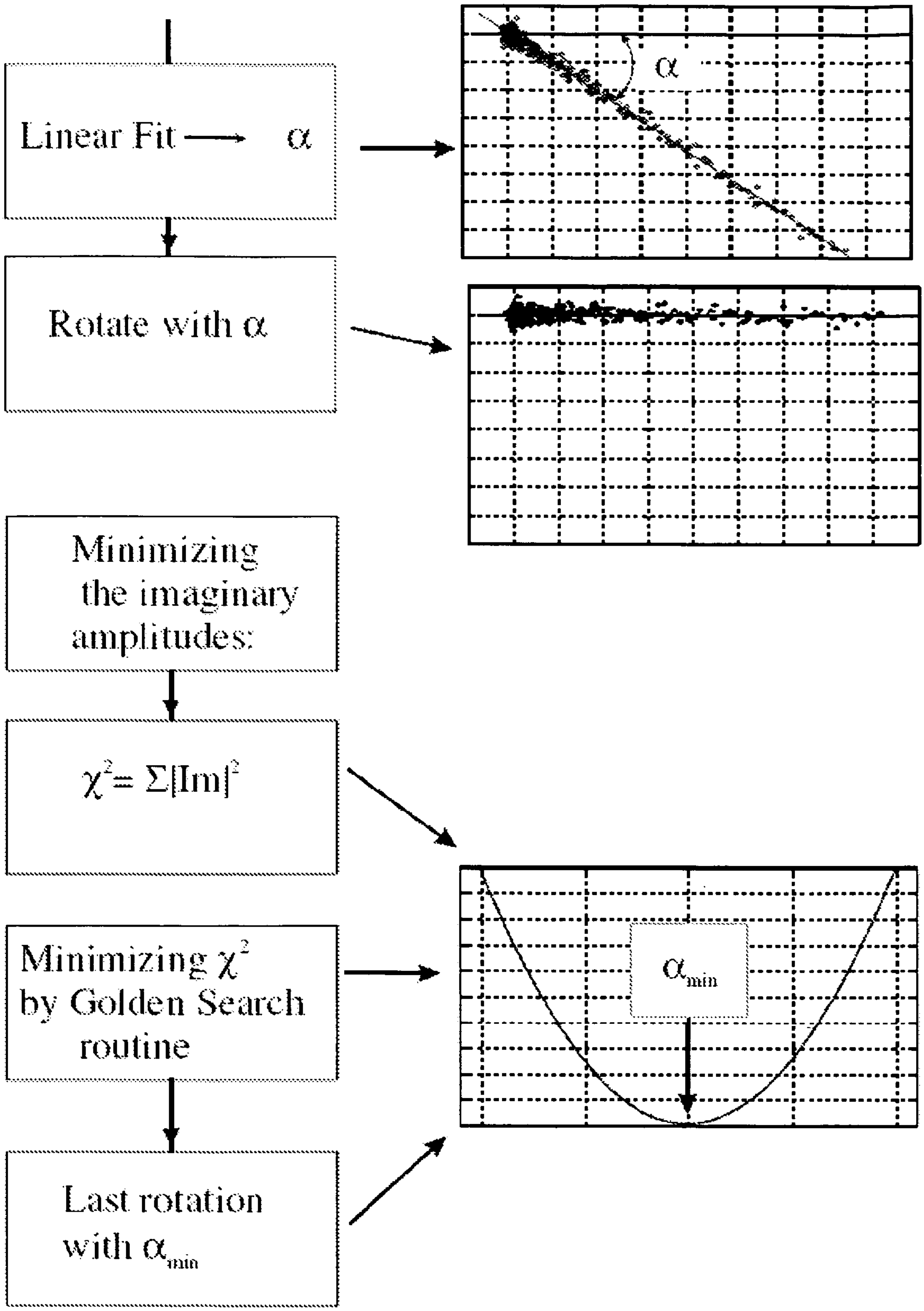
Linear Fit → α
α
Rotate with α
Minimizing the imaginary amplitudes:
$\chi^2 = \Sigma|Im|^2$
Minimizing $\chi^2$ by Golden Search routine
$\alpha_{min}$
Last rotation with $\alpha_{min}$

FIGURE 3

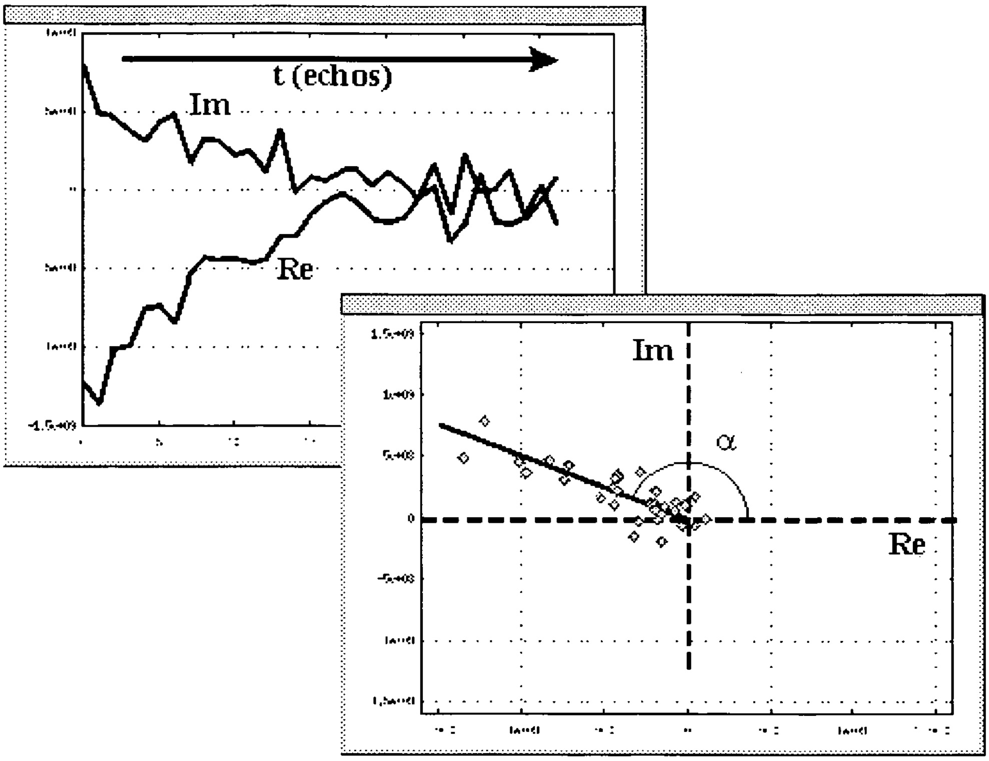


FIGURE 4a

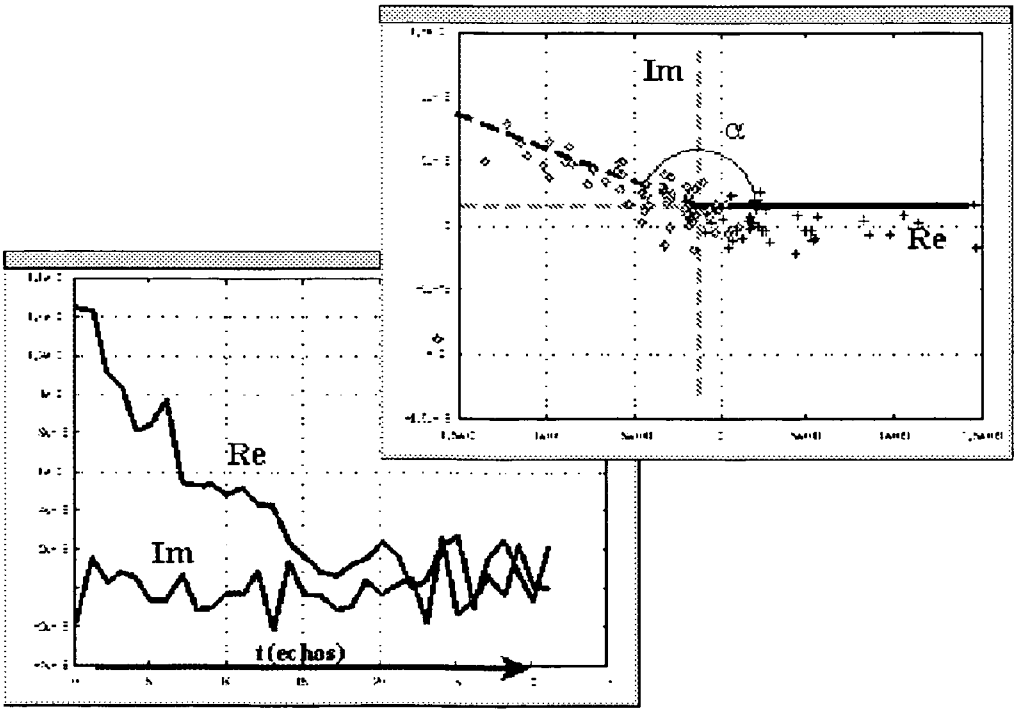


FIGURE 4b

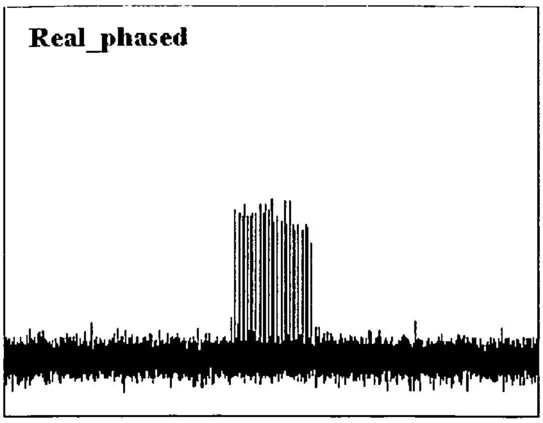


FIGURE 5a

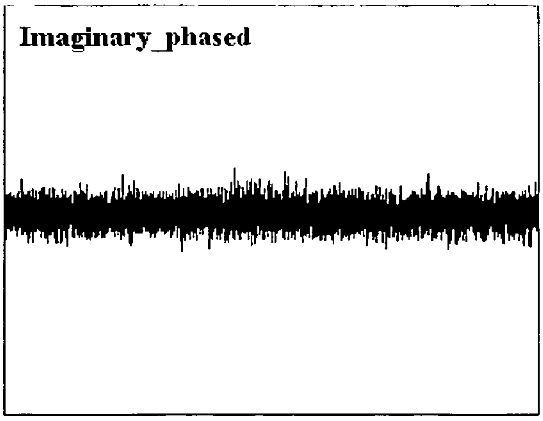


FIGURE 5b

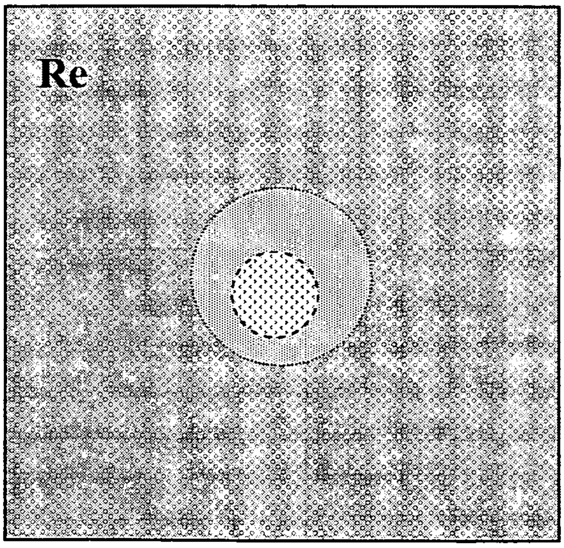


FIGURE 5c

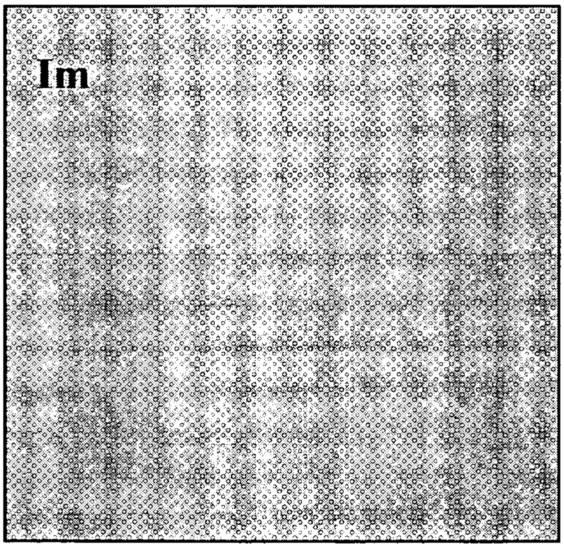


FIGURE 5d

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **LOUISE VAN DER WEERD ; FRANK J. VERGELDT ; P. ADRIE DE JAGER ; HENK VAN AS.** Evaluation of Algorithms for Analysis of NMR Relaxation Decay Curves. *Magnetic Resonance Imaging,* 2000, vol. 18, 1151-1157